# FASCICULE DE BREVET EUROPEEN

(11) **EP 3 984 340 B1**
(45) Date de publication et mention de la délivrance du brevet: **09.08.2023**
(21) Numéro de dépôt: 20733526.6
(22) Date de dépôt: 09.06.2020
(51) Int. Cl.: H05K 7/14

(54) **BAIE AVIONIQUE D'AERONEF A PLATEAU D'INTERCONNEXION**
FLUGZEUG AVIONIKSCHRANK MIT VERBINDUNGSPLATTE
AIRCRAFT AVIONICS BAY WITH INTERCONNECTION PLATE

(30) Priorité: 11.06.2019 FR 1906195
(43) Date de publication de la demande: 20.04.2022
(73) Titulaire: LATELEC, 31500 Toulouse (FR)
(72) Inventeur: MOURIERAS, Julien, 31500 Toulouse (FR); PUERTOLAS, Bastien, 31280 Aigrefeuille (FR)
(74) Mandataire: Junca, Eric
(86) Numéro de dépôt international: PCT/EP2020/025268
(87) Numéro de publication internationale: WO 2020/249258

(56) Documents cités:
- EP-A1- 3 024 309
- CN-A- 104 302 128
- FR-A1- 2 927 222
- FR-A1- 2 977 446
- FR-A1- 2 977 447

## Description

### DOMAINE TECHNIQUE

L'invention a trait au domaine de l'aéronautique et concerne les baies avioniques d'aéronefs.

Les baies avioniques sont des armoires électriques embarquées dans un aéronef, qui permettent de loger des équipements électriques ou électroniques, tels que des calculateurs ou autres instruments, ainsi que les câblages électriques raccordant ces équipements. Ces baies avioniques sont généralement de taille conséquente et contiennent de nombreux équipements électroniques ou électriques proches les uns des autres, ainsi qu'une grande quantité de câbles. Une baie avionique comporte généralement un dispositif de racks permettant l'insertion et le retrait des équipements, en assurant leur support mécanique et leur connexion électrique. Ces dispositifs de racks garantissent un haut niveau de sécurité dans la gestion des équipements électriques, aussi bien en fonctionnement normal que durant les phases de maintenance.

### ART ANTÉRIEUR

Les baies avioniques d'aéronef comportent généralement des étagères permettant le support des équipements électriques ou électroniques.

Le document US 4458296 décrit une structure d'étagère pour baie avionique. L'étagère décrite comporte une plateforme de support sur laquelle sont montées des chaises de maintien pour module électrique rackable, chaque chaise de maintien comportant un connecteur. Les connecteurs de toutes les chaises de maintien sont reliés à une interface de connexion externe destinée à être raccordée au circuit électrique de l'aéronef. La liaison entre les connecteurs des chaises de maintien et l'interface de connexion externe est réalisée par des câblages électriques agencés en différents faisceaux maintenus par des rampes ou par des goulottes.

Compte tenu de la complexité des modules électriques à raccorder, ces câblages représentent une masse, un encombrement, et un cout conséquents qu'il conviendrait de réduire. Par ailleurs, lors de la fabrication des baies avioniques, ce type de câblage impose de nombreuses opérations manuelles à réaliser par du personnel qualifié.

Le document FR2977447 divulgue un baie avionique avec une carte électronique fond de panier qui s'étendant en vis-a-vis de tous les connecteurs et aucun circuit imprimé individuellement par connecteur de module. La connexion interne entre fond de panier et module d'interface latéral est faite par câblage du côté de l'étagère et donc ce baie avionique résolve seulement partiellement les inconvénients décrits cidessus.

Le document FR2927222 divulgue un principe d'arrangement de rack d'appareillages électroniques, particulièrement de rack avionique. Il décrit un fond de panier qui est connecté à des modules d'interface et à des modules fonctionnels, les modules d'interface jouant le rôle d'intermédiaire entre le fond de panier et l'infrastructure de l'avion.

Le document FR2977446 divulgue une baie avionique, dans laquelle des connecteurs électriques sont placés en dessous, au-dessus ou sur le côté de la structure principale, de sorte que les connexions à l'infrastructure de l'avion peuvent être réalisées en tirant de nombreux câbles.

Le document EP3024309 divulgue une structure d'installation mécanique comprenant une matrice de connexion, de sorte que des modules électroniques peuvent être connectés correctement dans différentes configurations, en utilisant des modules de configuration qui réalisent les connexions électriques requises.

Le document CN104302128 divulgue une baie avionique avec une plate-forme de support et des chaises de maintien pour des modules électriques rackable, ces chaises de maintien étant montées sur la plate-forme de support, chaque chaise de maintien comportant une paroi de fond sensiblement perpendiculaire à la plateforme de support, et un connecteur de module monté sur cette paroi de fond.

### EXPOSÉ DE L'INVENTION

L'invention a pour but d'améliorer les baies avioniques de l'art antérieur.

A cet effet, l'invention vise une baie avionique d'aéronef comportant un agencement de racks destiné à l'intégration d'équipements et de connexions électriques, cette baie avionique étant munie d'au moins une étagère qui comprend :
- une plateforme de support ;
- des chaises de maintien pour module électrique rackable, ces chaises de maintien étant montées sur la plateforme de support, chaque chaise de maintien comportant une paroi de fond sensiblement perpendiculaire à la plateforme de support, et un connecteur de module monté sur cette paroi de fond ;

- une interface de connexion externe, destinée à être raccordée au circuit électrique de l'aéronef, montée sur la plateforme de support et reliée aux connecteurs de module. Ladite étagère comporte :
- un plateau d'interconnexion s'étendant sensiblement parallèlement à la plateforme de support, du coté opposé aux chaises de maintien, ce plateau d'interconnexion portant des pistes conductrices de liaison ;
- une pluralité de circuits imprimés arrière, chaque circuit imprimé arrière s'étendant en vis-à-vis d'un connecteur de module ;
les pistes conductrices de liaison du plateau d'interconnexion s'étendant dans chaque circuit imprimé arrière et dans l'interface de connexion externe par des conducteurs flexibles.

Dans une telle baie avionique, un important gain de volume, d'accessibilité et de cout est réalisé grâce à l'agencement du plateau d'interconnexion et des circuits imprimés arrière. Aucun câble n'est nécessaire pour relier les connecteurs de modules à l'interface de connexion externe.

Les parties mobiles de l'interconnexion sont réduites au minimum et la fonction d'interconnexion dans son ensemble ne requiert pas, ou peu, de maintenance.

La fabrication d'une telle baie avionique est grandement simplifiée par la suppression de toutes les opérations de câblage manuel impliquant le passage de câbles et leur fixation sur des rampes ou goulottes.

L'invention permet ainsi une fabrication rapide et à cout réduit d'une baie avionique pour aéronef qui se révèle être plus fiable et nécessiter moins de maintenance que les baie avioniques embarquant un câblage traditionnel.

Par ailleurs, les règlementations aéronautiques ont actuellement tendance à exiger, pour des raisons de sécurité, la multiplication des chemins de câble dans l'interconnexion des baies avioniques. Cette multiplication des chemins de câble est facilement réalisée au sein de la baie avionique selon l'invention car le plateau d'interconnexion offre une surface propice à la multiplication des chemins de pistes conductrices de liaison, sans augmenter l'encombrement ni la masse de la baie avionique.

L'invention permet ainsi la mise en oeuvre des nouvelles règlementations pour des aéronefs embarquant de plus en plus de matériel électronique et électrique, matériel dont la complexité augmente.

La baie avionique selon l'invention peut comporter les caractéristiques additionnelles suivantes, seules ou en combinaison :
- chaque circuit imprimé arrière est fixé sur le connecteur de module en vis-à-vis duquel il s'étend ;
- chaque circuit imprimé arrière et son connecteur de module correspondant sont fixés de part et d'autre d'une entretoise ;
- l'entretoise comporte une paroi de rebord s'étendant perpendiculairement au circuit imprimé arrière et disposée sur le pourtour du circuit imprimé arrière ;
- chaque connecteur de module comporte des broches raccordées au circuit imprimé arrière sur lequel il est fixé ;
- les broches de chaque connecteur de module sont raccordées au circuit imprimé arrière correspondant par des tiges conductrices rigides ;
- les tiges conductrices rigides sont serties ou soudées dans le circuit imprimé arrière correspondant ;
- chaque chaise de maintien comporte une fenêtre de connexion pratiquée dans sa paroi de fond, chaque connecteur de module comportant une paroi de connexion qui est fixée sur la paroi de fond de la chaise de maintien correspondante par des fixations vissées dans l'entretoise, de sorte que le connecteur de module est saillant de la fenêtre de connexion ;
- chaque circuit imprimé arrière est relié aux pistes conductrices de liaison du plateau d'interconnexion par un circuit imprimé flexible ;
- l'interface de connexion externe comporte un circuit imprimé de connexion externe sur lequel sont raccordés des connecteurs d'interface, le circuit imprimé de connexion externe étant relié aux pistes conductrices de liaison du plateau d'interconnexion par un circuit imprimé flexible ;
- l'interface de connexion externe comporte une paroi de connexion externe fixée sensiblement perpendiculairement à la plateforme de support, les connecteurs d'interface ainsi que le circuit imprimé de connexion externe étant fixés sur cette paroi de connexion ;
- chaque connecteur d'interface comporte des broches raccordées au circuit imprimé de connexion externe ;
- les broches des connecteurs d'interface sont raccordées au circuit imprimé de connexion externe par des tiges conductrices rigides ;
- lesdites tiges conductrices rigides sont serties ou soudées dans le circuit imprimé de connexion externe ;
- les circuits imprimés flexibles connectés aux circuits imprimés arrière sont reliés aux pistes conductrices de liaison du plateau d'interconnexion par l'intermédiaire d'un connecteur détachable ;
- le circuit imprimé flexible connecté au circuit imprimé de connexion externe est relié aux pistes conductrices de liaison du plateau d'interconnexion par l'intermédiaire d'un connecteur détachable ;
- le plateau d'interconnexion, les circuits imprimés arrière, le circuit imprimé de connexion externe, et les circuits imprimés flexibles sont formés d'un unique circuit imprimé comportant des portions rigides et des portions flexibles ;
- la plateforme de support est constituée de deux traverses planes parallèles formées par deux profilés latéraux de l'étagère ;
- le plateau d'interconnexion est fixé sur l'étagère par une agrafe flexible de mise au potentiel de référence ;
- le plateau d'interconnexion comporte un capot de protection fixé sur l'étagère et s'étendant sensiblement sur toute la surface du plateau d'interconnexion ;
- le plateau d'interconnexion est constitué d'un circuit imprimé rigide dans lequel sont gravées les pistes conductrices de liaison ;
- la baie avionique comporte un dispositif de refroidissement par circulation d'un gaz traversant les modules électriques rackables, et en ce que ladite étagère comporte une paroi de ventilation qui s'étend parallèlement à la plateforme de support, l'étagère formant un caisson de ventilation du dispositif de refroidissement, entre la plateforme de support et la paroi de ventilation, le plateau d'interconnexion étant disposé face à la paroi de ventilation ;
- la paroi de ventilation et le plateau d'interconnexion comportent chacun des orifices de ventilation traversants ;
- le plateau d'interconnexion comporte autant d'orifices de ventilation que la paroi de ventilation, chaque orifice de ventilation du plateau d'interconnexion étant en vis-à-vis d'un orifice de ventilation de la paroi de ventilation ;
- le plateau d'interconnexion comporte un capot de protection fixé sur l'étagère et s'étendant sensiblement sur toute la surface du plateau d'interconnexion, ce capot de protection comportant des orifices de ventilation traversants ;
- la paroi de ventilation comporte une fenêtre de ventilation, le plateau d'interconnexion obturant cette fenêtre de ventilation, le plateau d'interconnexion comportant des orifices de ventilation traversants ;
- un joint d'étanchéité est serré entre le plateau d'interconnexion et la paroi de ventilation, sur le pourtour de la fenêtre de ventilation ;
- le plateau d'interconnexion comporte un capot de protection fixé sur l'étagère et s'étendant sensiblement sur toute la surface du plateau d'interconnexion, ce capot de protection comportant des orifices de ventilation traversants ;
- le capot de protection comporte autant d'orifices de ventilation que le plateau d'interconnexion, chaque orifice de ventilation du capot de protection étant disposé en vis-à-vis d'un orifice de ventilation du plateau d'interconnexion ;
- la baie avionique comporte un dispositif de refroidissement par circulation d'un gaz traversant les modules électriques rackables, et l'étagère forme un caisson de ventilation du dispositif de refroidissement, ce caisson étant délimité par le plateau d'interconnexion et la plateforme de support, le plateau d'interconnexion comportant des orifices de ventilation traversants ;
- le plateau d'interconnexion comporte un capot de protection fixé sur l'étagère et s'étendant sensiblement sur toute la surface du plateau d'interconnexion, ce capot de protection comportant des orifices de ventilation traversants ;
- le capot de protection comporte autant d'orifices de ventilation que le plateau d'interconnexion, chaque orifice de ventilation du capot de protection étant disposé en vis-à-vis d'un orifice de ventilation du plateau d'interconnexion ;
- la baie avionique comporte une coque de protection pour chaque circuit imprimé arrière, cette coque de protection comportant des pattes de maintien du plateau d'interconnexion ;
- la baie avionique comporte un équipement en façade d'étagère, cet équipement étant relié par un circuit imprimé flexible supplémentaire au plateau d'interconnexion.

### PRÉSENTATION DES FIGURES

D'autres caractéristiques et avantages de l'invention ressortiront de la description non limitative qui suit, en référence aux dessins annexés dans lesquels :
[Fig.1] La figure 1 illustre une baie avionique selon l'invention ;
[Fig.2] La figure 2 représente une étagère de la baie avionique de la figure 1 ;
[Fig.3] La figure 3 représente l'étagère de la figure 2, les connecteurs de module et l'interface de connexion externe étant démontés ;
[Fig.4] La figure 4 représente l'ensemble d'interconnexion de l'étagère de la figure 2 ;
[Fig.5] La figure 5 représente l'étagère de la figure 3 vue de dessous ;
[Fig.6] La figure 6 représente l'étagère de la figure 2 vue en coupe ;
[Fig.7] La figure 7 représente une agrafe de mise au potentiel de référence, de l'étagère de la figure 2 ;
[Fig.8] La figure 8 représente une languette de l'étagère de la figure 2 ;
[Fig.9] La figure 9 représente l'agrafe de la figure 7 vue en coupe ;
[Fig.10] La figure 10 illustre une variante de l'agrafe de la figure 7 ;
[Fig.11] La figure 11 représente l'agrafe de la figure 10 montée sur une étagère ;
[Fig.12] La figure 12 est une vue similaire à la figure 6 pour un deuxième mode de réalisation de l'invention ;
[Fig.13] La figure 13 est une vue similaire à la figure 6 pour un troisième mode de réalisation de l'invention ;
[Fig.14] La figure 14 est une vue agrandie de l'encadré XIV de la figure 6.

### DESCRIPTION DÉTAILLÉE

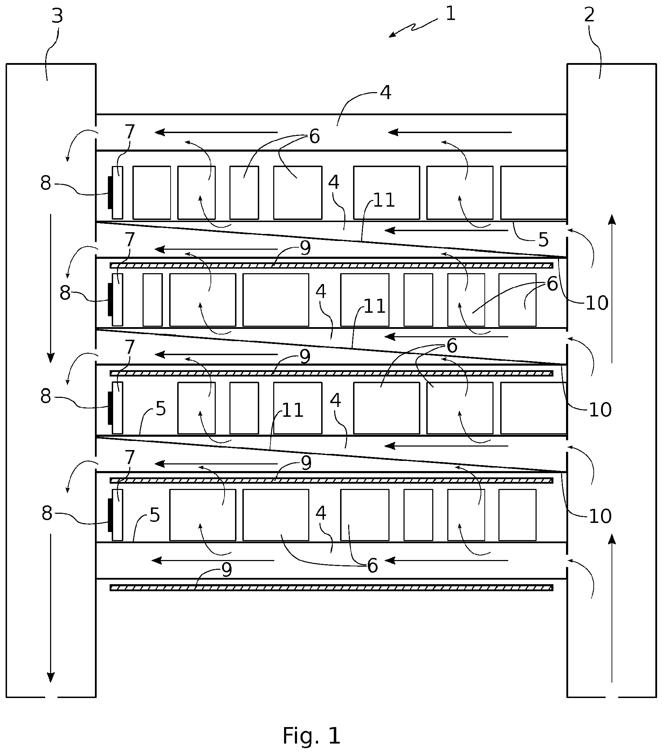

La figure 1 est une représentation schématique d'une baie avionique 1 selon l'invention.

Cette baie avionique 1 comporte deux montants latéraux 2, 3 entre lesquels s'étendent des étagères 4. Chacune des étagères 4 est formée d'un caisson dont la partie creuse s'étend entre une paroi de ventilation 10 et une plateforme de support 5 pour des modules électriques rackables 6 montés sur l'étagère 4.

Les modules électriques 6 sont par exemple des dispositifs électriques, d'électronique de puissance, de calcul relatif aux fonctions de navigation, de sécurité, de climatisation, etc. Ces modules 6 sont dits rackables car ils sont montés sur les étagères 4 de manière amovible, grâce à des chaises de maintien (non représentées sur cette vue schématique de la figure 1) pour faciliter la maintenance et le remplacement de ces modules. Ces modules électriques rackables 6 sont également dénommés LRU (« Line-Replaceable Unit », en anglais). Il s'agit par exemple de modules conformes à la norme aéronautique ARINC.

Chaque étagère 4 comporte, en plus des modules 6, une interface de connexion externe 7 munie de connecteurs d'interface 8. Le circuit électrique de l'aéronef est relié à la baie avionique 1 par l'intermédiaire de ces connecteurs d'interface 8.

L'interface de connexion externe 7 de chaque étagère 4 est reliée à chacun des modules 6 montés sur cette étagère 4 par l'intermédiaire d'un plateau d'interconnexion 9 s'étendant parallèlement à la plateforme de support 5, du côté opposé aux modules 6. Autrement dit, la plateforme de support 5 est située entre les modules 6 et le plateau d'interconnexion 9, pour chaque étagère 4.

Dans le présent exemple, la baie avionique 1 comporte également un dispositif de refroidissement par circulation d'air. Ce dispositif de refroidissement permet de maintenir les équipements électriques et électroniques des modules 6 à une température acceptable compte tenu de leur nombre important, de leur densité, et de la chaleur qu'ils dégagent.

Ce dispositif de refroidissement organise une circulation d'air représentée schématiquement sur la figure 1 par des flèches. Dans le présent exemple, l'air frais est injecté dans la baie avionique 1 par l'un de ses montants 2 puis est distribué dans les étagères 4 formant des caissons canalisant cet air frais pour traverser les modules 6. Différentes portions de chaque étagère 4 sont percées d'orifices de ventilation traversants (non représentés sur cette vue schématique de la figure 1) permettant à l'air de refroidissement de traverser le module 6 pour le refroidir.

L'air réchauffé en traversant les modules 6 est ensuite récupéré dans les étagères 4 qui évacuent l'air chaud vers l'autre montant 3 de la baie avionique 1 pour ensuite être évacué de la baie avionique 1.

Des parois de séparation de flux 11 au sein des caissons formés par les étagères 4 permettent de séparer les flux d'air frais et d'air chaud dans chaque étagère 4 si nécessaire.

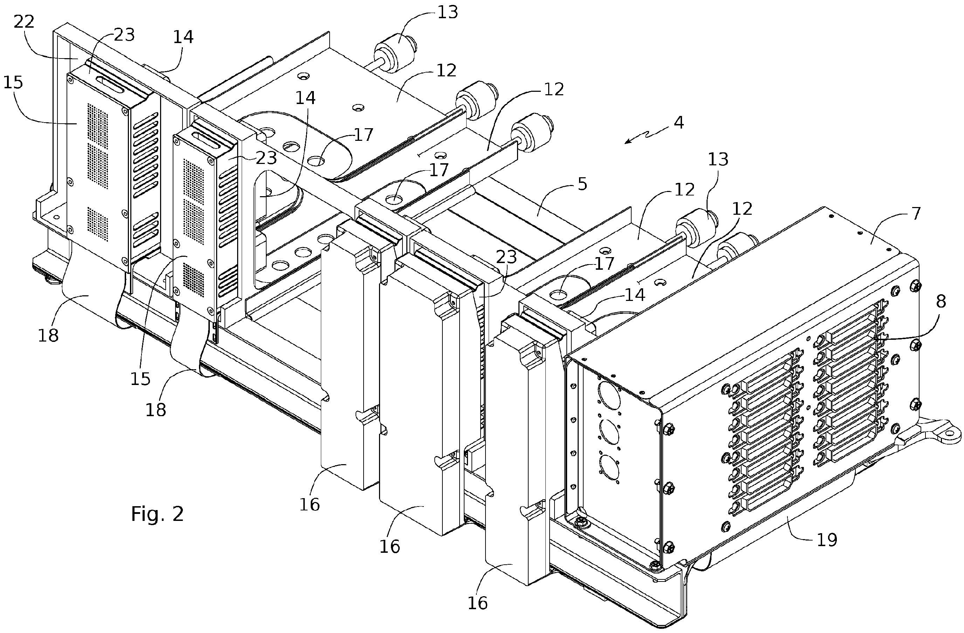

La figure 2 représente l'une des étagères 4 de la baie avionique 1. Sur cette figure 2, les modules 6 n'ont pas été représentés. Seules les chaises de maintien 12 destinées à recevoir ces modules 6 ont été représentées sur la figure 2. Dans le présent exemple, les chaises de maintien 12 sont conformes à la norme ARINC et permettent la fixation mécanique et la connexion électrique de modules 6 compatibles. Le verrouillage mécanique est assuré notamment par des molettes 13 tandis que la connexion électrique des modules 6 est assurée par des connecteurs 14 de module.

Dans l'exemple illustré sur la figure 2, cinq chaises de maintien 12 sont montées sur la plateforme de support 5 de l'étagère 4 permettant donc de recevoir cinq modules électriques rackables, de les fixer par les molettes 13 et de les raccorder électriquement au circuit électrique de l'aéronef grâce aux connecteurs 14 de module. Les molettes 13 sont disposées sur la partie avant des chaises de maintien 12, c'est-à-dire la partie qui est accessible par l'utilisateur quand il est face à la baie avionique.

Comme décrit précédemment, l'étagère 4 comporte également une interface de connexion externe 7 munie de connecteurs d'interface 8 permettant de relier tous les modules de l'étagère 4 au circuit électrique de l'aéronef, pour alimenter électriquement et communiquer avec tous les modules 6 qui sont destinés à être montés dans les chaises de maintien 12. L'interface de connexion externe 7 est également fixée sur la plateforme de support 5.

L'étagère 4 comporte de plus une pluralité de circuits imprimés arrière 15 rigides. Un circuit imprimé arrière 15 est prévu pour chaque connecteur 14 de module. Chacun des circuits imprimés arrière 15 est ainsi disposé en vis-à-vis du connecteur 14 de module d'une chaise de maintien 12. Chaque circuit imprimé arrière 15 et son connecteur 14 de module correspondant sont rigidement fixés l'un à l'autre.

Les circuits imprimés arrière 15 sont chacun protégés par une coque de protection 16. Sur la figure 2, trois des circuits imprimés arrière 15 ont été représentés avec leur coque de protection 16, tandis que deux des circuits imprimés arrière 15 sont montrés dépourvus de leur coque de protection 16 pour rendre visible les circuits imprimés arrière 15.

Les chaises de maintien 12 sont chacune percées d'orifices de ventilation 17 traversant permettant au flux d'air frais issu de l'étagère 4 de traverser le module 6 qui sera monté sur cette chaise de maintien 12.

Chacun des circuits imprimés arrière 15, d'une part, et l'interface de connexion externe 7, d'autre part, sont reliés au plateau d'interconnexion 9 (non visible sur la figure 2) par un circuit imprimé flexible 18, 19.

Chaque coque de protection 16 protège avantageusement un circuit imprimé arrière 15 et également son circuit imprimé flexible 18.

Les coques de protection 16 sont de plus munies en leur partie basse de pattes de maintien 61 ou d'ergots dépassants pour assurer le maintien du plateau d'interconnexion 9 une fois installées à l'arrière de chaque circuit imprimé arrière 15. Les coques de protection 16 assurent ainsi une fonction supplémentaire de maintien du plateau d'interconnexion 9.

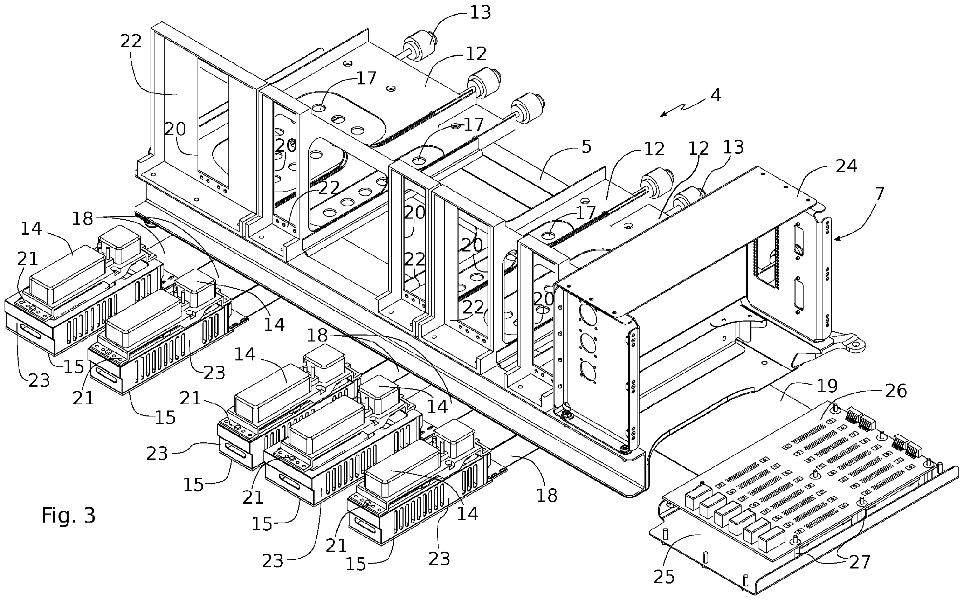

La figure 3 représente l'étagère de la figure 2 avec ses connecteurs 14 de module démontés et avec son interface de connexion externe 7 ouverte.

Chacune des chaises de maintien 12 comporte une paroi de fond 22 s'étendant perpendiculairement à la plateforme de support 5, et dans laquelle est pratiquée une fenêtre de connexion 20. Chaque connecteur 14 de module est monté sur une paroi de connexion 21 qui est fixée (lorsque l'étagère est dans sa position montée de la figure 1) sur les rebords de la fenêtre de connexion 20 de sorte que le connecteur 14 de module est saillant de la fenêtre de connexion 20 pour pouvoir connecter le module reçu dans la chaise de maintien 12. Les parois de connexion 21 et les connecteurs 14 de module s'étendent ainsi chacun perpendiculairement à la plateforme de support 5.

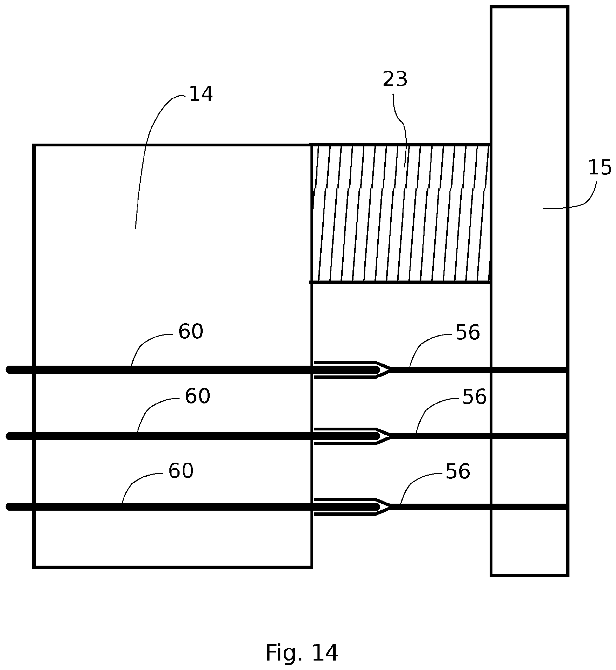

Les connecteurs 14 de module peuvent être de tout type approprié pour assurer la connexion d'un module 6 lorsqu'il est inséré dans la chaise de maintien 12 correspondante jusqu'à venir en butée contre sa paroi de fond 22. Les connecteurs 14 de module peuvent être d'une seule pièce ou au contraire constitués de plusieurs sous-connecteurs. Ces connecteurs 14 de module sont munis de broches s'étendant parallèlement à la plateforme de support 5, en direction du module installé sur la chaise de maintien 12. Ces broches sont des broches d'interconnexion qui sont avantageusement démontables et remplaçables. Ces broches 60 sont représentées plus en détail à la figure 14.

Pour chaque chaise de maintien 12, la paroi de connexion 21 est solidaire du circuit imprimé arrière 15 grâce à une entretoise 23. L'entretoise 23 est ici constituée d'une paroi de rebord s'étendant perpendiculairement au circuit imprimé arrière et disposée sur le pourtour du circuit imprimé arrière. La paroi de connexion 21 est fixée d'un côté de l'entretoise 23 et le circuit imprimé arrière 15 est fixé de l'autre côté de l'entretoise 23, le circuit imprimé étant ainsi parallèle à la paroi de connexion 21. La paroi de connexion 21 peut avantageusement être fixée sur la paroi de fond 22 par des fixations vissées dans l'entretoise 23.

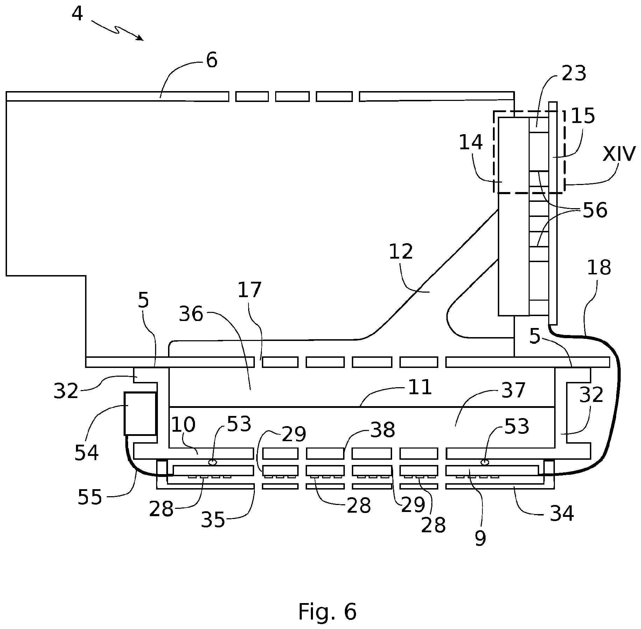

Les broches du connecteur 14 de module sont reliées au circuit imprimé arrière 15 correspondant par tout moyen de câblage tel que par liaison de conducteurs soudés, ou plus avantageusement par des technologies d'enfichage en force de type « press-fit » (en anglais). Les broches de chaque connecteur 14 de module sont ainsi démontables et prolongées par des tiges conductrices rigides qui sont serties dans le circuit imprimé arrière 15 correspondant. Ces tiges conductrices rigides sont couramment dénommées « tulipes ». La réalisation du montage et du raccordement des connecteurs 14 de module est ainsi rapide et sure. Les tiges conductrices 56 sont représentées figures 6, 12 et 13, ainsi qu'à la figure 14, qui est une vue agrandie de l'encadré XIV de la figure 6. Les broches 60 du connecteur 14 et les tiges conductrices 56 sont reliées par enfichage.

La fixation rigide assurée par l'entretoise 23 permet ici l'emploi de connexions rigides entre le connecteur 14 de module et le circuit imprimé arrière 15 et garantit la longévité de ces connexions dans le temps grâce à un montage où les mouvements relatifs du connecteurs 14 de module et du circuit imprimé arrière correspondant 15 ne sont pas permis.

La figure 3 rend visible la possibilité de mouvement des connecteurs 14 de module lorsqu'ils ont été démontés de leur fenêtre de connexion 20. Ce mouvement est permis par la souplesse des circuits imprimés flexibles 18. La fixation, pour chaque module, de la paroi de connexion 21 sur la fenêtre de connexion 20 se fait de préférence par des vis accessibles depuis l'intérieur de la chaise de maintien 12, c'est-à-dire depuis la face avant (du côté des molettes 13) de l'étagère. Un opérateur peut ainsi facilement accéder à un connecteur 14 de module, en extrayant le module d'une chaise de maintien 12, en dévissant ces vis, et en positionnant le connecteur 14 dans sa position de la figure 3 grâce à la flexibilité du circuit imprimé flexible 18.

En ce qui concerne l'interface de connexion externe 7, celle-ci est constituée d'un boitier de connexion 24 comportant une paroi de connexion externe 25 (qui est montrée démontée sur la figure 3). Un circuit imprimé de connexion externe 26 est fixé parallèlement à la paroi de connexion externe 25 grâce à des entretoises 27 et est relié au circuit imprimé flexible 19.

Les connecteurs d'interface 8 (visibles à la figure 2) sont raccordés au circuit imprimé de connexion externe 26 de manière similaire au connecteur 14 de module. Les connecteurs d'interface 8 comportent ainsi des broches (non représentées pour simplifier les figures) reliées par toute technique appropriée aux pistes du circuit imprimé de connexion externe 26, et notamment par technologie d'enfichage en force permise par le maintien rigide du circuit imprimé de connexion externe 26 par rapport à la paroi de connexion externe 25. Les broches de chaque connecteur d'interface 8 sont ainsi prolongées par des tiges conductrices rigides qui sont serties dans le circuit imprimé de connexion externe 26. Les broches des connecteurs d'interface 8 et ces tiges conductrices rigides peuvent être montées de la même manière que les broches 60 et les tiges 56 des connecteurs 14 de module (c'est-à-dire de la manière illustrée à la figure 14).

L'interface de connexion externe 7 fournit ainsi, au niveau des connecteurs d'interface 8, la connectique permettant de raccorder toutes les broches des connecteurs 14 de module au circuit électrique de l'aéronef. Le boitier de connexion 24 permet par ailleurs de loger des équipements supplémentaires tels que fusibles, connecteurs ou afficheurs destinés à la maintenance, ces équipements supplémentaires pouvant être directement montés sur le circuit imprimé de connexion externe 26.

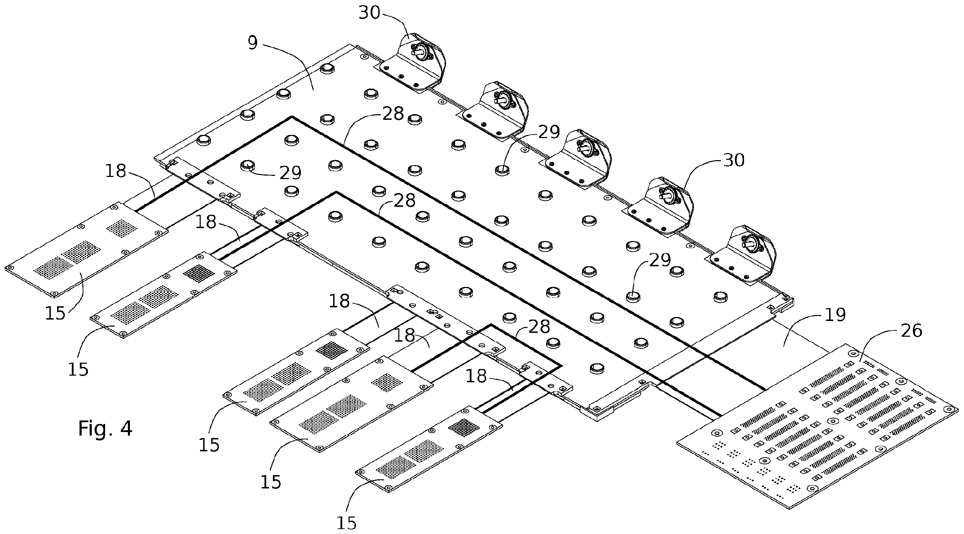

La figure 4 illustre la réalisation de la liaison électrique entre les connecteurs 14 de module et les connecteurs d'interface 8. Cette figure 4 représente un ensemble d'interconnexion dont les circuits imprimés flexibles 18, 19 et rigides 15, 26 ont été représentés, dans une position à plat illustrant une position préférée pour la fabrication de cet ensemble d'interconnexion.

Les circuits imprimés arrière 15 et le circuit imprimé de connexion externe 26 sont chacun reliés au plateau d'interconnexion 9 grâce à leur circuit imprimé flexible 18, 19 respectifs. Dans le présent exemple, le plateau d'interconnexion 9 est un circuit imprimé portant des pistes conductrices de liaison 28 reliant les circuits imprimés flexibles 18 aux circuits imprimés flexibles 19 et éventuellement certains circuits imprimés flexibles 18 entre eux. Les pistes conductrices de liaisons 28 s'étendent, en continu ou avec d'éventuelles interconnexions, des circuits imprimés arrière 15 au circuit imprimé de connexion externe 26.

Sur la figure 4, seules quelques pistes conductrices de liaison 28 ont été schématisées, étant entendu qu'un nombre important de modules 6 peut être monté sur une étagère 4 ce qui génère une grande quantité de connexions électriques de faible et forte puissance à assurer entre les connecteurs 14 de module et les connecteurs d'interface 8 ou entre deux connecteurs 14. La surface du plateau d'interconnexion 9 n'étant limitée que par la surface de l'étagère 4 elle-même, cette surface du plateau d'interconnexion 9 peut être adaptée à ces nombreuses pistes conductrices 28 à supporter. Le plateau d'interconnexion 9 peut de plus être constitué par un circuit imprimé à plusieurs couches si le nombre de pistes conductrices 28 l'exige.

Chaque broche d'un connecteur 14 de module peut ainsi être reliée à une broche d'un connecteur d'interface 8 par un circuit passant par le circuit imprimé arrière 15, le circuit imprimé flexible 18, le plateau d'interconnexion 9, au circuit imprimé flexible 19, et au circuit imprimé de connexion externe 26.

Le plateau d'interconnexion 9 comporte par ailleurs une pluralité d'orifices de ventilation 29 traversant destinés à participer à la fonction de refroidissement de la baie avionique.

Le plateau d'interconnexion 9 comporte de plus des agrafes 30 de mise au potentiel de référence permettant à la fois le maintien mécanique du plateau d'interconnexion 9 par rapport à l'étagère 4 correspondante et la liaison électrique de la masse du plateau d'interconnexion 9 avec la structure métallique de l'étagère 4. Les modules 6 et l'interface de connexion externe 7 peuvent ainsi être mis à la masse de la baie avionique 1 de manière fiable par des pistes conductrices du plateau d'interconnexion 9.

Selon une caractéristique préférée, le plateau d'interconnexion 9, les circuits imprimés arrière 15, le circuit imprimé de connexion externe 26 ainsi que les circuits imprimés flexibles 18, 19 sont fabriqués d'une seule pièce. L'ensemble d'interconnexion représenté à la figure 4 (à l'exception des agrafes 30) est ainsi constitué par un unique circuit imprimé qui comporte des portions rigides 15, 9, 26, et des portions flexibles 18, 19. Cependant, le plateau d'interconnexion 9 peut être également constitué circuit imprimé flexible.

Une fabrication extrêmement rapide et fiable est ainsi permise pour le système d'interconnexion complet de la figure 4.

En variante, si des propriétés de modularité sont préférées pour l'ensemble d'interconnexion, les circuits imprimés flexibles 18 reliés aux circuits imprimés arrière 15 peuvent être connectés au plateau d'interconnexion 9 par l'intermédiaire de connecteurs détachables ce qui permet d'enlever ou d'ajouter des circuits imprimés arrière 15, et donc des connecteurs 14 de module, à un même plateau d'interconnexion 9.

De même, le circuit imprimé flexible 19 du circuit imprimé de connexion externe 26 peut être soit réalisé d'une seule pièce avec le plateau d'interconnexion 9 ou, en variante, connecté par des connecteurs détachables permettant de changer le circuit imprimé de connexion externe 26 pour le remplacer s'il est défectueux, ou pour avoir le choix de connecter différentes interfaces de connexion externes 7 sur un même plateau d'interconnexion 9.

Les circuits imprimés flexibles 18, 19 permettent ici de relier des éléments perpendiculaires entre eux. Une faible contrainte de courbure est donc imposée à ces circuits imprimés flexibles 18, 19, ce qui est un gage de fiabilité.

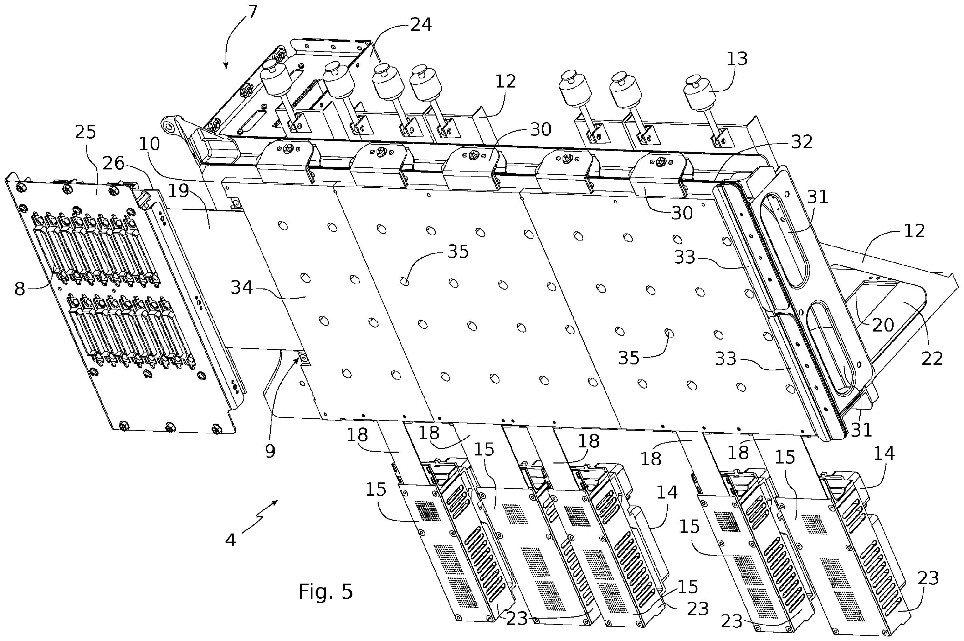

La figure 5 représente l'étagère 4 de la figure 3, vue de dessous. La figure 5 illustre un premier mode de réalisation de l'assemblage du plateau d'interconnexion 9 avec l'étagère 4.

Dans cet exemple, l'étagère 4 forme un caisson à l'intérieur duquel circule l'air de refroidissement qui entre et sort du caisson par des bouches d'aération 31. La plateforme de support 5 délimite la partie supérieure de ce caisson tandis que la paroi de ventilation 10 délimite la partie inférieure de ce caisson, des profilés latéraux 32 délimitant de plus les bords latéraux du caisson.

Le plateau d'interconnexion 9 est fixé en vis-à-vis de la paroi de ventilation 10 grâce aux agrafes 30 de mise au potentiel de référence qui sont fixées sur l'un des profilés latéraux 32 ainsi que par des agrafes complémentaires 33 dont la fonction est uniquement de pincer le plateau d'interconnexion 9 et de le fixer sur la paroi de ventilation 10. De plus, comme décrit précédemment, les coques de protection 16 comportent des pattes de maintien 61 du plateau d'interconnexion 9 et participent ainsi également au maintien optimal du plateau d'interconnexion 9.

Sur la figure 5, le plateau d'interconnexion 9 est muni d'un capot de protection 34 recouvrant quasiment toute sa superficie pour assurer sa protection physique et son isolation électrique. Le capot de protection 34 est de plus muni luimême d'orifices de ventilation 35 traversant disposés en vis-à-vis des orifices de ventilation 29 du plateau d'interconnexion 9.

La figure 6 est une vue schématique en coupe transversale montrant l'agencement relatif à ce premier mode de réalisation. Sur cette figure 6, un module 6, représenté en coupe, est monté sur une chaise de maintien. Le caisson délimité par l'étagère 4 comporte un conduit d'entrée 36 et un conduit de sortie 37 qui sont séparés par la paroi de séparation de flux 11.

Dans le présent exemple, la plateforme de support 5 est constituée de deux rebords horizontaux des profilés latéraux 32 formant deux traverses planes parallèles sur lesquelles s'appuient les chaises de maintien. La partie supérieure du conduit d'entrée 36 est close par les chaises de maintien et le calibrage de la section de passage de l'air de refroidissement distribué au module 6 est réalisé par le diamètre et le nombre des orifices de ventilation 17 des chaises de maintien.

Comme évoqué précédemment en relation à la figure 1, le conduit d'entrée 36 distribue l'air frais au module 6 par l'intermédiaire des orifices de ventilation 17 de la chaise de maintien et le conduit de sortie 37 permet l'aspiration de l'air chaud qui a traversé le module 6 qui se trouve sur l'étagère du dessous (non représentée). Selon ce premier mode de réalisation, cet air chaud est aspiré dans le conduit de sortie 37 successivement à travers les orifices de ventilation 35 du capot de protection 34, puis les orifices de ventilation 29 du plateau d'interconnexion 9, puis des orifices de ventilation 38 traversant de la paroi de ventilation 10, ces orifices étant de préférence en vis-à-vis comme représenté sur la figure 6.

En variante de la figure 6, les orifices de ventilation 29 du plateau d'interconnexion 9 sont plus petits que les orifices de ventilation 35, 38 du capot de protection 34 et de la paroi de ventilation 10. Les orifices de ventilation 35, 38 du capot de protection 34 et de la paroi de ventilation 10 sont donc sur-dimensionnés tandis que les orifices de ventilation 29 du plateau d'interconnexion 9 assurent le calibrage de la perméabilité à l'air de l'entrée du conduit de sortie 37. Le calibrage de cette perméabilité à l'air est un élément important du système de refroidissement qui est déterminé lors de la conception de la baie avionique, en fonction de l'agencement des différents éléments permettant la génération et la canalisation de l'air de refroidissement. Le calibrage de cette perméabilité étant réalisé par le plateau d'interconnexion, les étagères (et notamment les parois de ventilation) et les capots de protection 34 peuvent être standardisés.

Le plateau d'interconnexion 9 est directement fixé sur l'étagère 4 (voire sur la paroi de ventilation 10), avec ou sans joint d'étanchéité 53 ou entretoise maintenant un écartement entre cette paroi 10 et le plateau d'interconnexion 9. Dans le présent exemple la fixation du plateau d'interconnexion 9 est assurée par les agrafes 30 de mise au potentiel de référence.

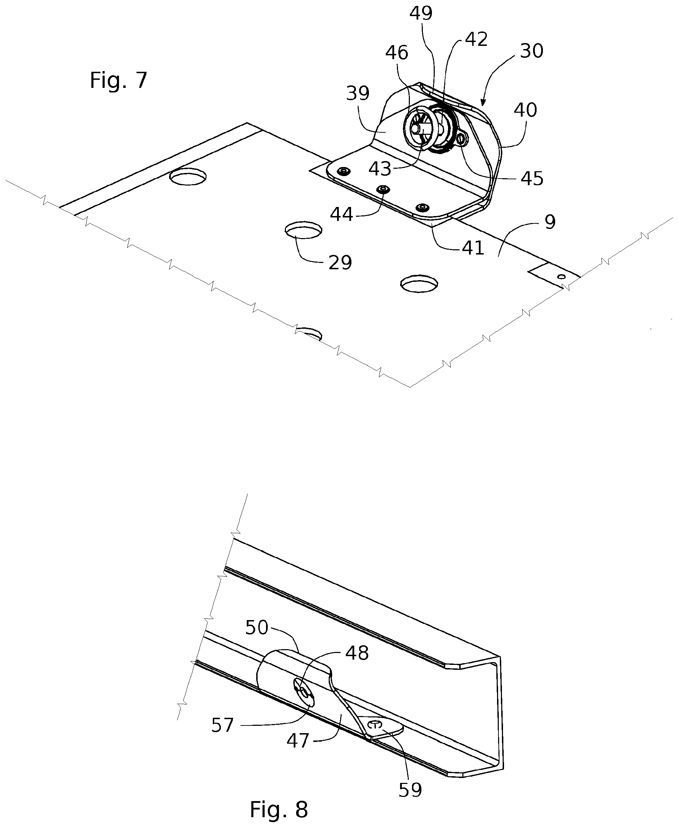

Les figures 7 à 9 illustrent l'une des agrafes 30 de mise au potentiel de référence qui permettent de relier le plateau d'interconnexion 9 au potentiel électrique de référence et qui permet le maintien mécanique de ce plateau d'interconnexion 9.

L'agrafe 30 est une agrafe flexible constituée d'une pince formée de deux mâchoires 39, 40 serrant entre elles le plateau d'interconnexion 9. Au moins l'une des deux faces du plateau d'interconnexion 9 qui est en contact avec l'agrafe 30 comporte une plage conductrice de masse 41. Les pistes conductrices du plateau d'interconnexion 9 qui doivent être reliées au potentiel électrique de référence de la baie avionique devront être électriquement connectées à cette plage conductrice 41.

L'agrafe 30 est réalisée en un matériau électriquement conducteur de sorte que, lorsque l'agrafe 30 est serrée sur le plateau d'interconnexion 9, la continuité électrique est établie entre la plage conductrice 41 et un talon 42 qui est solidaire de l'une des deux mâchoires 39, 40. Le talon 42 comporte en son centre un orifice permettant le passage d'une vis de fixation 43.

Optionnellement, pour une meilleure longévité et sécurité de connexion, l'agrafe 30 est serrée par des rivets 44 sur le plateau d'interconnexion 9 et les deux mâchoires 39, 40 sont serrées l'une contre l'autre par des rivets 45 de part et d'autre du talon de mise au potentiel 42.

Un joint torique 46 peut par ailleurs être disposé autour du talon de mise au potentiel 42 pour assurer l'étanchéité de la mise au potentiel.

La figure 8 représente en perspective une portion de l'un des profilés latéraux 32 de l'étagère 4, cette portion étant destinée à recevoir la fixation de l'agrafe 30. A cet effet, le profilé latéral 32 comporte une languette 47 électriquement et mécaniquement reliée au profilé latéral 32 par exemple par soudure ou comme illustré à la figure 8, par rivetage. La languette 47 comporte un écrou serti 48 pour sa coopération avec la vis de fixation 43.

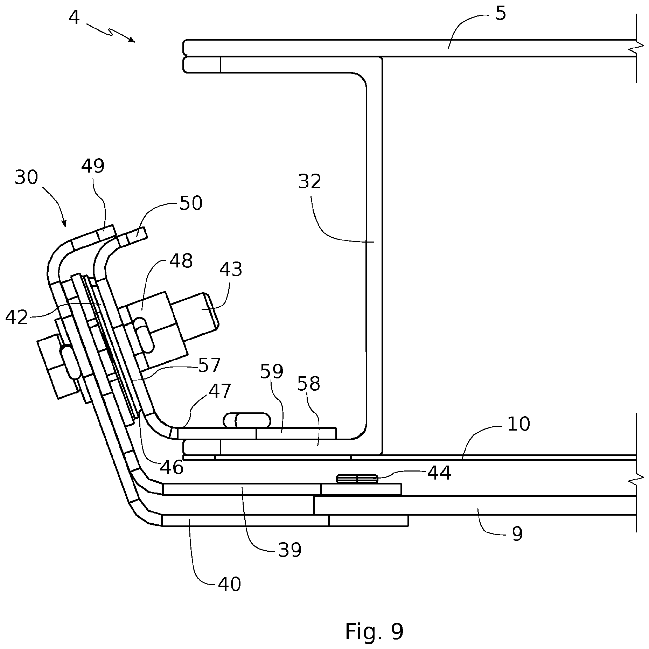

La figure 9 représente en coupe, au niveau de l'agrafe 30, l'assemblage d'un plateau d'interconnexion 9 et d'une étagère 4. La vis de fixation 43 est vissée et serrée sur l'écrou serti 48 de sorte que le joint torique 46 soit comprimé et que le talon de mise au potentiel 42 soit pressé contre la languette 47.

L'agrafe 30 procure ainsi un maintien mécanique du plateau d'interconnexion 9 sans le bloquer en place grâce à la flexibilité de l'agrafe 30 et de la languette 47. Ceci permet d'éviter les contraintes mécaniques au sein du circuit imprimé constituant le plateau d'interconnexion 9, et ce tout en assurant un maintien ferme de ce plateau d'interconnexion 9. Le montage du plateau d'interconnexion 9 et sa mise au potentiel de référence est réalisé par la seule opération de serrage de la vis de fixation 43. Afin de favoriser la mise en place de l'agrafe 30 par rapport à la languette 47, l'agrafe 30 comporte un rebord 49 et la languette 47 comporte un rebord 50 ces deux rebords 49, 50 étant en contact plan sur plan lorsque la vis de fixation 43 est en vis-à-vis de l'écrou serti 48.

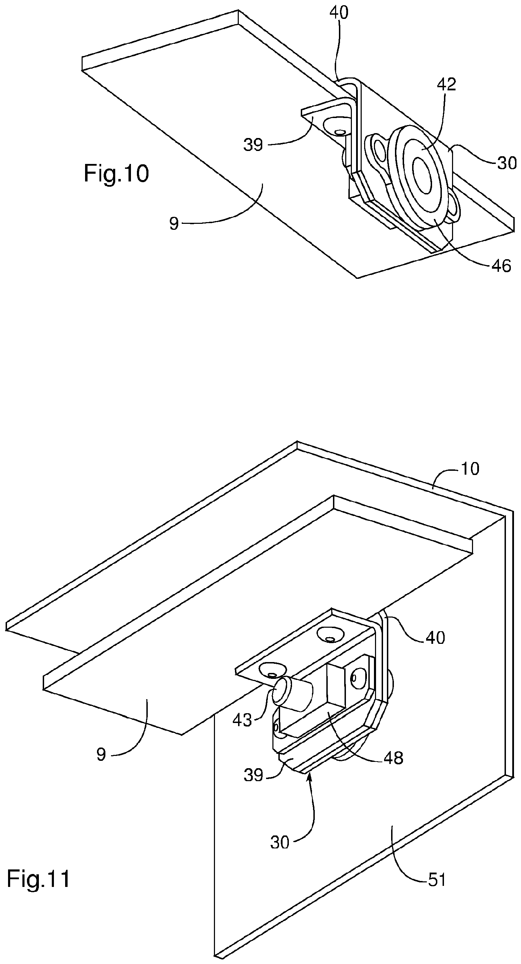

Les figures 10 et 11 illustrent une variante de réalisation de l'agrafe 30 de mise au potentiel de référence. Dans cette variante, la paroi de ventilation 10 comporte un rebord perpendiculaire 51 et le montage du plateau d'interconnexion 9 en vis-à-vis de la paroi de ventilation 10 est réalisé par fixation de l'agrafe 30 sur ce rebord 51. Les deux mâchoires 39, 40 de l'agrafe 30 sont ici constituées de pièces en forme d'équerre adaptées à serrer le plateau d'interconnexion 9 et à le maintenir perpendiculairement au rebord 51 tout en assurant sa mise au potentiel de référence.

Les agrafes 30 suppriment la nécessité de recourir à des tresses, des câbles et des cosses de masse généralement employés en plus des moyens de fixation classiques de circuit imprimé.

Le montage et la connexion sur une étagère 4 d'un tel ensemble d'interconnexion est réalisé par un nombre très restreint d'opérations réduites à la fixation des agrafes 30, 33 sur l'étagère 4, la fixation des parois de connexion 21 sur les chaises de maintien 12, et le montage de l'interface de connexion externe 7. Ces opérations de montage sont d'un nombre très limité comparé aux multiples opérations de câblage nécessaires dans les baies avioniques de l'art antérieur, et ce avec une plus grande sécurité de connexion en limitant les risques d'erreur.

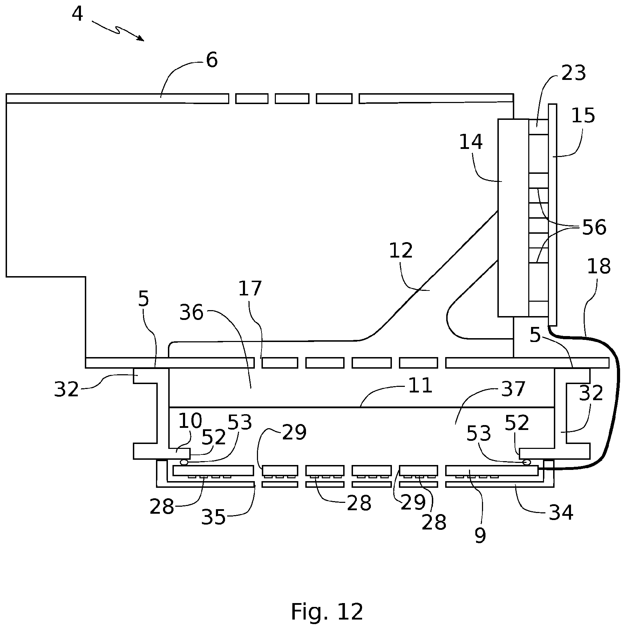

La figure 12 illustre un deuxième mode de réalisation de l'assemblage du plateau d'interconnexion 9 avec le reste de l'étagère 4. Selon ce deuxième mode de réalisation, la paroi de ventilation 10 ne comporte pas d'orifices de ventilation mais comporte à la place une fenêtre de ventilation 52 créant une large ouverture dans le conduit de sortie 37. Le plateau d'interconnexion 9 est ici réalisé par un circuit imprimé rigide et éventuellement renforcé qui est directement fixé sur l'étagère 4 en comprimant un joint d'étanchéité 53. Dans ce deuxième mode de réalisation, le calibrage de la perméabilité définie pour l'entrée du conduit de sortie 37 est alors réalisé par le nombre et la dimension des orifices de ventilation 29 du plateau d'interconnexion 9.

Ce deuxième mode de réalisation permet d'alléger l'étagère 4 en supprimant la quasi-totalité de l'une de ses parois (la paroi de ventilation 10) et en transférant au plateau d'interconnexion 9 cette fonction de calibration de perméabilité.

Dans le premier et deuxième mode de réalisation, l'ajustement du plateau d'interconnexion 9 sur l'étagère 4 à l'aide du joint 53 permet de simplifier la fabrication de l'étagère 4 en permettant des tolérances géométriques et des états de surface moins précis dans la mesure où la calibration de la perméabilité à l'air de refroidissement est directement réalisée par le plateau d'interconnexion 9. Le joint d'étanchéité 53 permet un déplacement relatif entre le plateau d'interconnexion 9 et l'étagère 4 préservant ainsi l'intégrité de la carte électronique constituant le plateau d'interconnexion 9 sous les déformations et mouvements de l'étagère 4, liés par exemple aux vibrations et aux sollicitations de la baie avionique.

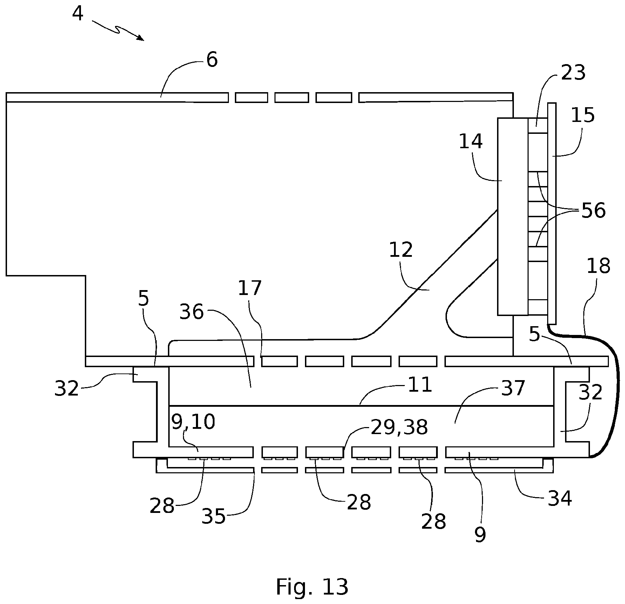

La figure 13 illustre un troisième mode de réalisation de l'assemblage du plateau d'interconnexion 9 avec le reste de l'étagère 4.

Dans ce troisième mode de réalisation, la paroi de ventilation 10 et le plateau d'interconnexion 9 forment une seule et même pièce qui est réalisée en un matériau non conducteur de l'électricité, tel qu'un polymère ou un matériau composite. Le plateau d'interconnexion 9 est formé d'une paroi obturant la partie inférieure de l'étagère 4, paroi sur laquelle les pistes conductrices de liaison 28 sont gravées, déposées, ou collées.

Selon ce troisième mode de réalisation, la masse et le cout d'une étagère 4 sont encore plus réduites.

En variante, les pistes conductrices de liaison 28 peuvent être intégrées dans l'épaisseur du plateau d'interconnexion 9 par des procédés de type « Plastronique ».

Des variantes de réalisation de la baie avionique décrite peuvent être envisagées sans sortir du cadre de l'invention. Par exemple, le choix d'un plateau d'interconnexion 9 rigide peut conduire à sous-dimensionner l'étagère 4. Il est possible par exemple de diminuer les épaisseurs prévues pour les parois de l'étagère 4, et notamment l'épaisseur de la paroi de ventilation 10 en prenant en compte la rigidité supplémentaire apportée par la fixation du plateau d'interconnexion 9 sur l'étagère 4.

De même, si le choix d'un plateau d'interconnexion 9 en circuit imprimé flexible est réalisé, il est possible de prévoir une étagère 4 souple voire déformable, la souplesse du plateau d'interconnexion 9 accompagnant cette déformation sans induire de contrainte qui pourrait nuire aux pistes conductrices de liaison 28.

Les coques de protection 16 des circuits imprimés arrière 15 et les capots de protection 34 du plateau d'interconnexion peuvent de plus assurer des fonctions de compatibilité électromagnétiques par exemple en isolant électromagnétiquement leur contenu.

L'intégration de composants en face avant de l'étagère 4 est rendue possible par le système d'interconnexion. La figure 6 illustre ainsi un exemple d'intégration d'un équipement 54 en façade d'étagère 4. Cet équipement peut par exemple comporter des afficheurs, des relais, des touches de commande. Cet équipement 54 de façade ne nécessite aucun autre câblage particulier que l'ajout d'un circuit imprimé flexible 55 supplémentaire relié d'une part à cet équipement de façade 54 et d'autre part au plateau d'interconnexion 9.

Par ailleurs, des nappes de câbles peuvent remplacer les circuits imprimés flexibles 18, 19 reliant les circuits imprimés arrière 15 et le circuit imprimé de connexion externe 26 au plateau d'interconnexion 9.

## Revendications

1. Baie avionique (1) d'aéronef comportant un agencement de racks destiné à l'intégration d'équipements et de connexions électriques, cette baie avionique étant munie d'au moins une étagère (4) qui comprend :
- une plateforme de support (5) ;
- des chaises de maintien (12) pour module électrique rackable (6), ces chaises de maintien (12) étant montées sur la plateforme de support (5), chaque chaise de maintien (12) comportant une paroi de fond (22) sensiblement perpendiculaire à la plateforme de support (5), et un connecteur (14) de module monté sur cette paroi de fond (22) ;
- une interface de connexion externe (7), destinée à être raccordée au circuit électrique de l'aéronef, montée sur la plateforme de support (5) et reliée aux connecteurs (14) de module ;
cette baie avionique étant **caractérisée en ce que** ladite étagère (4) comporte :
- un plateau d'interconnexion (9) s'étendant sensiblement parallèlement à la plateforme de support (5), du coté opposé aux chaises de maintien (12), ce plateau d'interconnexion (9) portant des pistes conductrices de liaison (28) ;
- une pluralité de circuits imprimés arrière (15), chaque circuit imprimé arrière (15) s'étendant en vis-à-vis d'un connecteur (14) de module ;
les pistes conductrices de liaison (28) du plateau d'interconnexion (9) s'étendant dans chaque circuit imprimé arrière (15) et dans l'interface de connexion externe (7) par des conducteurs flexibles (18, 19).

2. Baie avionique selon la revendication 1, **caractérisée en ce que** chaque circuit imprimé arrière (15) est fixé sur le connecteur (14) de module en vis-à-vis duquel il s'étend.

3. Baie avionique selon la revendication 2, **caractérisée en ce que** chaque circuit imprimé arrière (15) et son connecteur (14) de module correspondant sont fixés de part et d'autre d'une entretoise (23), comportant une paroi de rebord s'étendant perpendiculairement au circuit imprimé arrière (15) et disposée sur le pourtour du circuit imprimé arrière (15).

4. Baie avionique selon l'une des revendications 2 à 3, **caractérisée en ce que** chaque connecteur (14) de module comporte des broches (60) raccordées par des tiges conductrices rigides (56) au circuit imprimé arrière (15) sur lequel il est fixé.

5. Baie avionique selon l'une des revendications 3 à 4, **caractérisée en ce que** chaque chaise de maintien (12) comporte une fenêtre de connexion (20) pratiquée dans sa paroi de fond (22), chaque connecteur (14) de module comportant une paroi de connexion (21) qui est fixée sur la paroi de fond (22) de la chaise de maintien (12) correspondante par des fixations vissées dans l'entretoise (23), de sorte que le connecteur (14) de module est saillant de la fenêtre de connexion (20).

6. Baie avionique selon l'une quelconque des revendications précédentes, **caractérisée en ce que** chaque circuit imprimé arrière (15) est relié aux pistes conductrices de liaison (28) du plateau d'interconnexion (9) par un circuit imprimé flexible (18).

7. Baie avionique selon l'une quelconque des revendications précédentes, **caractérisée en ce que** l'interface de connexion externe (7) comporte un circuit imprimé de connexion externe (26) sur lequel sont raccordés des connecteurs d'interface (8), le circuit imprimé de connexion externe (26) étant relié aux pistes conductrices de liaison (28) du plateau d'interconnexion (9) par un circuit imprimé flexible (19).

8. Baie avionique selon la revendication 7, **caractérisée en ce que** l'interface de connexion externe (7) comporte une paroi de connexion externe (25) fixée sensiblement perpendiculairement à la plateforme de support (5), les connecteurs d'interface (8) ainsi que le circuit imprimé de connexion externe (26) étant fixés sur cette paroi de connexion (21).

9. Baie avionique selon l'une des revendications 7 ou 8, **caractérisée en ce que** chaque connecteur d'interface (8) comporte des broches raccordées par des tiges conductrices rigides au circuit imprimé de connexion externe (26).

10. Baie avionique selon la revendication 6, **caractérisée en ce que** les circuits imprimés flexibles (18) connectés aux circuits imprimés arrière (15) sont reliés aux pistes conductrices de liaison (26) du plateau d'interconnexion (9) par l'intermédiaire d'un connecteur détachable.

11. Baie avionique selon l'une des revendications 7 à 9, **caractérisée en ce que** le circuit imprimé flexible (19) connecté au circuit imprimé de connexion externe (26) est relié aux pistes conductrices de liaison (28) du plateau d'interconnexion (9) par l'intermédiaire d'un connecteur détachable.

12. Baie avionique selon la revendication 7 lorsqu'elle dépend de la revendication 6, **caractérisée en ce que** le plateau d'interconnexion (9), les circuits imprimés arrière (15), le circuit imprimé de connexion externe (26), et les circuits imprimés flexibles (18,19) sont formés d'un unique circuit imprimé comportant des portions rigides et des portions flexibles.

13. Baie avionique selon l'une quelconque des revendications précédentes, **caractérisée en ce que** la plateforme de support (5) est constituée de deux traverses planes parallèles formées par deux profilés latéraux (32) de l'étagère (4).

14. Baie avionique selon l'une quelconque des revendications précédentes, **caractérisée en ce que** le plateau d'interconnexion (9) est fixé sur l'étagère (4) par une agrafe flexible (30) de mise au potentiel de référence.

15. Baie avionique selon l'une quelconque des revendications précédentes, **caractérisée en ce que** le plateau d'interconnexion (9) est constitué d'un circuit imprimé rigide dans lequel sont gravées les pistes conductrices de liaison (28).

16. Baie avionique selon l'une quelconque des revendications précédentes, **caractérisée en ce qu'**elle comporte un dispositif de refroidissement par circulation d'un gaz traversant les modules électriques rackables (6), et **en ce que** ladite étagère (4) comporte une paroi de ventilation (10) qui s'étend parallèlement à la plateforme de support (5), l'étagère (4) formant un caisson de ventilation du dispositif de refroidissement, entre la plateforme de support (5) et la paroi de ventilation (10), le plateau d'interconnexion (9) étant disposé face à la paroi de ventilation (10).

17. Baie avionique selon la revendication 16, **caractérisée en ce que** la paroi de ventilation (10) et le plateau d'interconnexion (9) comportent chacun des orifices de ventilation (38,29) traversants.

18. Baie avionique selon la revendication 17, **caractérisée en ce que** le plateau d'interconnexion (9) comporte autant d'orifices de ventilation (29) que la paroi de ventilation (10), chaque orifice de ventilation (29) du plateau d'interconnexion (9) étant en vis-à-vis d'un orifice de ventilation (38) de la paroi de ventilation (10).

19. Baie avionique selon la revendication 16, **caractérisée en ce que** la paroi de ventilation (10) comporte une fenêtre de ventilation (52), le plateau d'interconnexion (9) obturant cette fenêtre de ventilation (52) et comportant des orifices de ventilation (29) traversants.

20. Baie avionique selon la revendication 19, **caractérisée en ce qu'**un joint d'étanchéité (53) est serré entre le plateau d'interconnexion (9) et la paroi de ventilation (10), sur le pourtour de la fenêtre de ventilation (52).

21. Baie avionique selon l'une des revendications 1 à 15, **caractérisée en ce que** elle comporte un dispositif de refroidissement par circulation d'un gaz traversant les modules électriques rackables (6), et **en ce que** l'étagère (4) forme un caisson de ventilation du dispositif de refroidissement, ce caisson étant délimité par le plateau d'interconnexion (9) et la plateforme de support (5), le plateau d'interconnexion (9) comportant des orifices de ventilation (29) traversants.

22. Baie avionique selon l'une des revendications 16 à 21, **caractérisée en ce que** le plateau d'interconnexion (9) comporte un capot de protection (34) fixé sur l'étagère (4) et s'étendant sensiblement sur toute la surface du plateau d'interconnexion (9), ce capot de protection (34) comportant des orifices de ventilation traversants (35).

23. Baie avionique selon la revendication 22, **caractérisée en ce que** le capot de protection (34) comporte autant d'orifices de ventilation (35) que le plateau d'interconnexion (9), chaque orifice de ventilation (35) du capot de protection (34) étant disposé en vis-à-vis d'un orifice de ventilation (29) du plateau d'interconnexion (9).

24. Baie avionique selon l'une quelconque des revendications précédentes, **caractérisée en ce qu'**elle comporte une coque de protection (16) pour chaque circuit imprimé arrière, cette coque de protection (16) comportant des pattes de maintien (61) du plateau d'interconnexion (9).

25. Baie avionique selon l'une quelconque des revendications précédentes, **caractérisée en ce qu'**elle comporte un équipement (54) en façade d'étagère (4), cet équipement (54) étant relié par un circuit imprimé flexible supplémentaire (55) au plateau d'interconnexion (9).

## Patentansprüche

1. Avionikschrank (1) eines Luftfahrzeugs, welcher eine Rackanordnung aufweist, die für den Einbau von elektrischen Einrichtungen und Verbindungen bestimmt ist, wobei dieser Avionikschrank mit mindestens einem Regal (4) ausgestattet ist, welches umfasst:
- eine Stützplattform (5);
- Haltesitze (12) für rackfähige elektrische Module (6), wobei diese Haltesitze (12) auf der Stützplattform (5) angebracht sind, wobei jeder Haltesitz (12) eine Bodenwand (22), die im Wesentlichen senkrecht zur Stützplattform (5) ist, und einen an dieser Bodenwand (22) angebrachten Modulverbinder (14) aufweist;
- eine externe Verbindungsschnittstelle (7), die dazu bestimmt ist, an die elektrische Anlage des Luftfahrzeugs angeschlossen zu werden, auf der Stützplattform (5) angebracht ist und mit den Modulverbindern (14) verbunden ist,
wobei dieser Avionikschrank **dadurch gekennzeichnet ist, dass** das Regal (4) aufweist:
- eine Verbindungsplatte (9), die sich im Wesentlichen parallel zur Stützplattform (5) auf der den Haltesitzen (12) gegenüberliegenden Seite erstreckt, wobei diese Verbindungsplatte (9) Verbindungsleiterbahnen (28) trägt;
- mehrere rückseitige Leiterplatten (15), wobei jede rückseitige Leiterplatte (15) sich gegenüber einem Modulverbinder (14) erstreckt;
wobei sich die Verbindungsleiterbahnen (28) der Verbindungsplatte (9) in jeder rückseitigen Leiterplatte (15) und in der externen Verbindungsschnittstelle (7) über flexible Leiter (18, 19) erstrecken.

2. Avionikschrank nach Anspruch 1, **dadurch gekennzeichnet, dass** jede rückseitige Leiterplatte (15) an dem Modulverbinder (14) befestigt ist, gegenüber dem sie sich erstreckt.

3. Avionikschrank nach Anspruch 2, **dadurch gekennzeichnet, dass** jede rückseitige Leiterplatte (15) und ihr entsprechender Modulverbinder (14) beiderseits eines Abstandsstücks (23) befestigt sind, das eine Randwand aufweist, die sich senkrecht zu der rückseitigen Leiterplatte (15) erstreckt und am Umfang der rückseitigen Leiterplatte (15) angeordnet ist.

4. Avionikschrank nach einem der Ansprüche 2 bis 3, **dadurch gekennzeichnet, dass** jeder Modulverbinder (14) Stifte (60) aufweist, die über starre leitfähige Stäbe (56) an die rückseitige Leiterplatte (15) angeschlossen sind, an welcher er befestigt ist.

5. Avionikschrank nach einem der Ansprüche 3 bis 4, **dadurch gekennzeichnet, dass** jeder Haltesitz (12) ein in seiner Bodenwand (22) ausgebildetes Verbindungsfenster (20) aufweist, wobei jeder Modulverbinder (14) eine Verbindungswand (21) aufweist, welche an der Bodenwand (22) des entsprechenden Haltesitzes (12) durch in das Abstandsstück (23) eingeschraubte Befestigungselemente befestigt ist, so dass der Modulverbinder (14) aus der Verbindungsfenster (20) herausragt.

6. Avionikschrank nach einem der vorhergehenden Ansprüche, **dadurch gekennzeichnet, dass** jede rückseitige Leiterplatte (15) mit den Verbindungsleiterbahnen (28) der Verbindungsplatte (9) durch eine flexible Leiterplatte (18) verbunden ist.

7. Avionikschrank nach einem der vorhergehenden Ansprüche, **dadurch gekennzeichnet, dass** die externe Verbindungsschnittstelle (7) eine externe Verbindungsleiterplatte (26) aufweist, an welcher Schnittstellenverbinder (8) angeschlossen sind, wobei die externe Verbindungsleiterplatte (26) mit den Verbindungsleiterbahnen (28) der Verbindungsplatte (9) durch eine flexible Leiterplatte (19) verbunden ist.

8. Avionikschrank nach Anspruch 7, **dadurch gekennzeichnet, dass** die externe Verbindungsschnittstelle (7) eine externe Verbindungswand (25) aufweist, die im Wesentlichen senkrecht zur Stützplattform (5) befestigt ist, wobei die Schnittstellenverbinder (8) sowie die externe Verbindungsleiterplatte (26) an dieser Verbindungswand (21) befestigt sind.

9. Avionikschrank nach einem der Ansprüche 7 oder 8, **dadurch gekennzeichnet, dass** jeder Schnittstellenverbinder (8) Stifte aufweist, die über starre leitfähige Stäbe an die externe Verbindungsleiterplatte (26) angeschlossen sind.

10. Avionikschrank nach Anspruch 6, **dadurch gekennzeichnet, dass** die flexiblen Leiterplatten (18), die mit den rückseitigen Leiterplatten (15) verbunden sind, mit den Verbindungsleiterbahnen (28) der Verbindungsplatte (9) über einen lösbaren Verbinder verbunden sind.

11. Avionikschrank nach einem der Ansprüche 7 bis 9, **dadurch gekennzeichnet, dass** die flexible Leiterplatte (19), die mit der externen Verbindungsleiterplatte (26) verbunden ist, mit den Verbindungsleiterbahnen (28) der Verbindungsplatte (9) über einen lösbaren Verbinder verbunden ist.

12. Avionikschrank nach Anspruch 7, wenn abhängig von Anspruch 6, **dadurch gekennzeichnet, dass** die Verbindungsplatte (9), die rückseitigen Leiterplatten (15), die externe Verbindungsleiterplatte (26) und die flexiblen Leiterplatten (18, 19) von einer einzigen Leiterplatte gebildet werden, die starre Abschnitte und flexible Abschnitte aufweist.

13. Avionikschrank nach einem der vorhergehenden Ansprüche, **dadurch gekennzeichnet, dass** die Stützplattform (5) aus zwei parallelen ebenen Querträgern besteht, die von zwei Seitenprofilen (32) des Regals (4) gebildet werden.

14. Avionikschrank nach einem der vorhergehenden Ansprüche, **dadurch gekennzeichnet, dass** die Verbindungsplatte (9) am Regal (4) durch eine flexible Klammer (30) zur Verbindung mit dem Bezugspotential befestigt ist.

15. Avionikschrank nach einem der vorhergehenden Ansprüche, **dadurch gekennzeichnet, dass** die Verbindungsplatte (9) aus einer starren Leiterplatte besteht, in welche die Verbindungsleiterbahnen (28) geätzt sind.

16. Avionikschrank nach einem der vorhergehenden Ansprüche, **dadurch gekennzeichnet, dass** er eine Vorrichtung zur Kühlung durch Zirkulation eines Gases, das die rackfähigen elektrischen Module (6) durchströmt, aufweist, und dadurch, dass das Regal (4) eine Lüftungswand (10) aufweist, welche sich parallel zur Stützplattform (5) erstreckt, wobei das Regal (4) einen Lüftungskasten der Kühlvorrichtung zwischen der Stützplattform (5) und der Lüftungswand (10) bildet, wobei die Verbindungsplatte (9) gegenüber der Lüftungswand (10) angeordnet ist.

17. Avionikschrank nach Anspruch 16, **dadurch gekennzeichnet, dass** die Lüftungswand (10) und die Verbindungsplatte (9) jeweils durchgehende Lüftungsöffnungen (38, 29) aufweisen.

18. Avionikschrank nach Anspruch 17, **dadurch gekennzeichnet, dass** die Verbindungsplatte (9) ebenso viele Lüftungsöffnungen (29) wie die Lüftungswand (10) aufweist, wobei jede Lüftungsöffnung (29) der Verbindungsplatte (9) einer Lüftungsöffnung (38) der Lüftungswand (10) gegenüberliegt.

19. Avionikschrank nach Anspruch 16, **dadurch gekennzeichnet, dass** die Lüftungswand (10) ein Lüftungsfenster (52) aufweist, wobei die Verbindungsplatte (9) dieses Lüftungsfenster (52) verschließt und durchgehende Lüftungsöffnungen (29) aufweist.

20. Avionikschrank nach Anspruch 19, **dadurch gekennzeichnet, dass** eine Dichtung (53) zwischen der Verbindungsplatte (9) und der Lüftungswand (10) am Umfang des Lüftungsfensters (52) eingeklemmt ist.

21. Avionikschrank nach einem der Ansprüche 1 bis 15, **dadurch gekennzeichnet, dass** er eine Vorrichtung zur Kühlung durch Zirkulation eines Gases, das die rackfähigen elektrischen Module (6) durchströmt, aufweist, und dadurch, dass das Regal (4) einen Lüftungskasten der Kühlvorrichtung bildet, wobei dieser Kasten von der Verbindungsplatte (9) und der Stützplattform (5) begrenzt wird, wobei die Verbindungsplatte (9) durchgehende Lüftungsöffnungen (29) aufweist.

22. Avionikschrank nach einem der Ansprüche 16 bis 21, **dadurch gekennzeichnet, dass** die Verbindungsplatte (9) eine Schutzhaube (34) aufweist, die am Regel (4) befestigt ist und sich im Wesentlichen über die gesamte Fläche der Verbindungsplatte (9) erstreckt, wobei diese Schutzhaube (34) durchgehende Lüftungsöffnungen (35) aufweist.

23. Avionikschrank nach Anspruch 22, **dadurch gekennzeichnet, dass** die Schutzhaube (34) ebenso viele Lüftungsöffnungen (35) wie die Verbindungsplatte (9) aufweist, wobei jede Lüftungsöffnung (35) der Schutzhaube (34) gegenüber einer Lüftungsöffnung (29) der Verbindungsplatte (9) angeordnet ist.

24. Avionikschrank nach einem der vorhergehenden Ansprüche, **dadurch gekennzeichnet, dass** er eine Schutzschale (16) für jede rückseitige Leiterplatte aufweist, wobei diese Schutzschale (16) Haltelaschen (61) für die Verbindungsplatte (9) aufweist.

25. Avionikschrank nach einem der vorhergehenden Ansprüche, **dadurch gekennzeichnet, dass** er ein Gerät (54) an der Vorderseite des Regals (4) aufweist, wobei dieses Gerät (54) über eine zusätzliche flexible Leiterplatte (55) mit der Verbindungsplatte (9) verbunden ist.

## Claims

1. An aircraft avionics bay (1) comprising an arrangement of racks intended for the integration of electrical equipment items and connections, this avionics bay being provided with at least one shelf (4) which comprises:
- a support platform (5);
- retaining seats (12) for a rackable electrical module (6), these retaining seats (12) being mounted on the support platform (5), each retaining seat (12) comprising an end wall (22) substantially perpendicular to the support platform (5), and a module connector (14) mounted on this end wall (22);
- an external connection interface (7) intended to be connected to the electrical circuit of the aircraft and mounted on the support platform (5) and connected to the module connectors (14);
this avionics bay being **characterized in that** said shelf (4) comprises:
- an interconnection plate (9) extending substantially parallel to the support platform (5), on the side opposite to the retaining seats (12), this interconnection plate (9) bearing conductive connection tracks (28);
- a plurality of rear printed circuits (15), each rear printed circuit (15) extending opposite a module connector (14);
the conductor connection tracks (28) of the interconnection plate (9) extending into each rear printed circuit (15) and into the external connection interface (7) via flexible conductors (18, 19).

2. The avionics bay as claimed in claim 1, **characterized in that** each rear printed circuit (15) is fixed to the module connector (14) opposite which it extends.

3. The avionics bay as claimed in claim 2, **characterized in that** each rear printed circuit board (15) and its corresponding module connector (14) are fixed on either side of a spacer (23) comprising a rebound wall extending perpendicularly to the rear printed circuit (15) and arranged on the periphery of the rear printed circuit (15).

4. The avionics bay as claimed in one of claims 2 to 3, **characterized in that** each module connector (14) comprises pins (60) connected by rigid conductive rods (56) to the rear printed circuit (15) to which it is fixed.

5. The avionics bay as claimed in one of claims 3 to 4, **characterized in that** each retaining seat (12) comprises a connection window (20) made in its end wall (22), each module connector (14) comprising a connection wall (21) which is fixed to the end wall (22) of the corresponding retaining seat (12) by fixings screwed into the spacer (23), with the result that the module connector (14) projects from the connection window (20).

6. The avionics bay as claimed in any one of the preceding claims, **characterized in that** each rear printed circuit (15) is connected to the conductive connection tracks (28) of the interconnection plate (9) by a flexible printed circuit (18).

7. The avionics bay as claimed in any one of the preceding claims, **characterized in that** the external connection interface (7) comprises an external connection printed circuit (26) to which interface connectors (8) are connected, the external connection printed circuit (26) being connected to the conductive connection tracks (28) of the interconnection plate (9) by a flexible printed circuit (19).

8. The avionics bay as claimed in claim 7, **characterized in that** the external connection interface (7) comprises an external connection wall (25) fixed substantially perpendicularly to the support platform (5), the interface connectors (8) and also the external connection printed circuit (26) being fixed to this connection wall (21).

9. The avionics bay as claimed in either of claims 7 and 8, **characterized in that** each interface connector (8) comprises pins connected by rigid conductive rods to the external connection printed circuit (26).

10. The avionics bay as claimed in claim 6, **characterized in that** the flexible printed circuits (18) connected to the rear print circuits (15) are connected to the conductive connection tracks (26) of the interconnection plate (9) via a detachable connector.

11. The avionics bay as claimed in one of claims 7 to 9, **characterized in that** the flexible printed circuit (19) connected to the external connection printed circuit (26) is connected to the conductive connection tracks (28) of the interconnection plate (9) via a detachable connector.

12. The avionics bay as claimed in claim 7 when it is dependent on claim 6, **characterized in that** the interconnection plate (9), the rear printed circuits (15), the external connection printed circuit (26), and the flexible printed circuits (18,19) are formed by a single printed circuit comprising rigid portions and flexible portions.

13. The avionics bay as claimed in any one of the preceding claims, **characterized in that** the support platform (5) is made up of two parallel planar crossmembers formed by two lateral profiles (32) of the shelf (4).

14. The avionics bay as claimed in any one of the preceding claims, **characterized in that** the interconnection plate (9) is fixed to the shelf (4) by a flexible reference potential setting fastener (30).

15. The avionics bay as claimed in any one of the preceding claims, **characterized in that** the interconnection plate (9) is made up of a rigid printed circuit in which the conductive connection tracks (28) are etched.

16. The avionics bay as claimed in any one of the preceding claims, **characterized in that** it comprises a device for cooling by circulation of a gas passing through the rackable electrical modules (6), and **in that** said shelf (4) comprises a ventilation wall (10) which extends parallel to the support platform (5), the shelf (4) forming a ventilation casing of the cooling device, between the support platform (5) and the ventilation wall (10), the interconnection plate (9) being arranged opposite the ventilation wall (10).

17. The avionics bay as claimed in claim 16, **characterized in that** the ventilation wall (10) and the interconnection plate (9) each comprise ventilation through-orifices (38, 29).

18. The avionics bay as claimed in claim 17, **characterized in that** the interconnection plate (9) comprises as many ventilation orifices (29) as the ventilation wall (10), each ventilation orifice (29) of the interconnection plates (9) being opposite a ventilation orifice (38) of the ventilation wall (10).

19. The avionics bay as claimed in claim 16, **characterized in that** the ventilation wall (10) comprises a ventilation window (52), the interconnection plate (9) closing off this ventilation window (52) and comprising ventilation through-orifices (29).

20. The avionics bay as claimed in claim 19, **characterized in that** a tightness seal (53) is clamped between the interconnection plate (9) and the ventilation wall (10), on the periphery of the ventilation window (52).

21. The avionics bay as claimed in one of claims 1 to 15, **characterized in that** it comprises a device for cooling by circulation of a gas passing through the rackable electrical modules (6), and **in that** the shelf (4) forms a ventilation casing of the cooling device, this casing being delimited by the interconnection plate (9) and the support platform (5), the interconnection plate (9) comprising ventilation through-orifices (29).

22. The avionics bay as claimed in one of claims 16 to 21, **characterized in that** the interconnection plate (9) comprises a protective cover (34) fixed to the shelf (4) and extending substantially over the whole surface of the interconnection plate (9), this protective cover (34) comprising ventilation through-orifices (35).

23. The avionics bay as claimed in claim 22, **characterized in that** the protective cover (34) comprises as many ventilation orifices (35) as the interconnection plate (9), each ventilation orifice (35) of the protective cover (34) being arranged opposite a ventilation orifice (29) of the interconnection plate (9).

24. The avionics bay as claimed in any one of the preceding claims, **characterized in that** it comprises a protective shell (16) for each rear printed circuit, this protective shell (16) comprising tabs (61) for retaining the interconnection plate (9).

25. The avionics bay as claimed in any one of the preceding claims, **characterized in that** it comprises an equipment item (54) in the facade of a shelf (4), this equipment item (54) being connected by an additional flexible printed circuit (55) to the interconnection plate (9).
